Europäisches Patentamt

(19) European Patent Office

Office européen des brevets

(11) Numéro de publication : **0 136 196**
**B1**

(12) # FASCICULE DE BREVET EUROPÉEN

(45) Date de publication du fascicule du brevet :
30.12.86

(21) Numéro de dépôt : **84401539.6**

(22) Date de dépôt : **20.07.84**

(51) Int. Cl.⁴ : **C 30 B 11/00**, C 30 B 15/00,
C 30 B 27/00, C 30 B 15/24

(54) **Procédé de préparation de formes métalliques ou semimétalliques minces ou massives, notamment de silicium.**

(30) Priorité : **29.07.83 FR 8312548**

(43) Date de publication de la demande :
**03.04.85 Bulletin 85/14**

(45) Mention de la délivrance du brevet :
**30.12.86 Bulletin 86/52**

(84) Etats contractants désignés :
**DE GB IT NL**

(56) Documents cités :
**DE-A- 2 300 989**
**DE-C- 407 415**
**US-A- 4 356 141**

(73) Titulaire : **COMMISSARIAT A L'ENERGIE ATOMIQUE
Etablissement de Caractère Scientifique Technique
et Industriel
31/33, rue de la Fédération
F-75015 Paris (FR)**

(72) Inventeur : **Potard, Claude
9, Boulevard Jomardiere
F-38120 Saint Egreve (FR)**

(74) Mandataire : **Mongrédien, André et al
c/o BREVATOME 25, rue de Ponthieu
F-75008 Paris (FR)**

## Description

La présente invention se rapporte au domaine de la fabrication de formes métalliques ou semimétalliques minces ou massives et notamment de plaques de silicium pour usage photovoltaïque.

Il est connu de préparer des plaques ou rubans de silicium par solidification du liquide entraîné par adhérence capillaire sur des supports réfractaires. Dans ces procédés, l'entraînement du liquide est réduit du fait des forces de pesanteur et des instabilités des surfaces et ménisques liquides. Ces inconvénients conduisent donc à solidifier de petites surfaces peu utilisables ou à réaliser, dans un processus continu un contrôle précis des formes liquides avant solidification. De plus, des formes autres que des plaques et rubans sont difficilement envisageables.

La présente invention a précisément pour objet un procédé de préparation de formes métalliques ou semimétalliques, planes, creuses ou massives qui permet, à l'aide de moyens simples, de réaliser celles-ci directement à partir de la mise en forme du liquide et présente l'avantage de réduire, dans une proportion très importante, les coûts de production.

Ce procédé de préparation de formes métalliques ou semimétalliques notamment de silicium, en bain d'enrobage fondu, du genre de ceux dans lesquels on met dans un creuset réfractaire de confinement le matériau métallique ou semimétallique de base à l'état fondu et un bain d'enrobage fondu inerte vis-à-vis du matériau et dont la température de fusion est inférieure à celle du matériau, se caractérise en ce que l'on introduit dans le matériau au moins une pièce en forme de cadre, en un matériau réfractaire dont l'aptitude au mouillage est plus grande vis-à-vis du matériau métallique ou semimétallique que vis-à-vis du bain d'enrobage fondu, puis on crée sur ce cadre, par déplacement lent de tout ou partie de celui-ci une forme de ce matériau métallique ou semimétallique que l'on solidifie par refroidissement dans le bain d'enrobage liquide pour extraire enfin l'ensemble du cadre et de la membrane solidifiée hors du bain.

Selon un premier mode de réalisation, la densité du bain fondu doit être voisine de celle du matériau métallique ou semimétallique à son point de fusion. Dans ce mode de réalisation, le choix du bain a pour but de compenser le poids du matériau métallique ou semimétallique à mettre en forme. Cette compensation des forces de gravité permet d'augmenter aussi l'effet des forces de capillarité.

On voit que le procédé objet de l'invention repose dans son principe sur la formation de formes ou de volumes creux ou pleins de métal ou semimétal liquide par étirement au sein d'un liquide sustentateur. Dans le cas de la formation de plaques, le métal ou semimétal liquide fondu dans un bain sustentateur est étendu à cet effet sur un cadre plan de matériau réfractaire pour former une membrane à faces parallèles. Il est ensuite solidifié sous cette forme au sein même du bain, lors du refroidissement du creuset de confinement, la feuille de métal ou semimétal ainsi solidifiée sur le cadre est dégagée avant qu'intervienne la solidification du bain dont le point de fusion est inférieur à celui du métal.

Le procédé, objet de l'invention, utilise principalement les propriétés d'aptitude différente au mouillage, du métal liquide d'une part et d'un bain d'enrobage d'autre part, vis-à-vis des matériaux réfractaires constituant la pièce en forme de cadre ; quels que soient les matériaux en présence choisis, il est nécessaire pour que le procédé, objet de l'invention, ait toute son efficacité, que le métal ou semimétal fondu ait la propriété de bien mouiller le matériau réfractaire constitutif du cadre.

La stabilité des surfaces du métal ou semimétal liquide est augmentée par le contact avec le bain fondu et les densités du bain fondu et du métal ou semimétal sont choisies très voisines de façon à permettre une sustentation des volumes de métal ou semimétal liquide dans le bain fondu.

La solidification peut s'effectuer le cas échéant de manière directionnelle de façon à créer les structures cristallines appropriées, notamment, à l'usage photovoltaïque quand il s'agit de silicium.

Selon une caractéristique secondaire mais importante de la présente invention, le bain fondu utilisé a une densité légèrement inférieure à celle du matériau métallique ou semimétallique fondu, celui-ci adhérant alors par mouillage au fond du creuset de confinement.

Dans une variante de réalisation, le bain fondu a une densité égale ou très voisine de celle du matériau métallique ou semimétallique fondu et celui-ci se rassemble sous forme d'une goutte unique de forme voisine de la sphère dans le creuset et la pièce en forme de cadre est déformable, l'un des côtés du cadre étant monté coulissant le long des deux autres côtés adjacents.

Selon une autre variante, le bain fondu a une densité légèrement supérieure à celle du matériau métallique ou semimétallique fondu, celui-ci se rassemblant alors sous forme de loupe flottant à la surface du bain et le cadre étant introduit à travers la loupe de silicium dans le bain fondu.

Dans un mode de mise en œuvre préférentiel du procédé objet de l'invention, le matériau traité est du silicium que l'on fabrique directement sous forme de plaque, et la pièce en forme de cadre est réalisée soit complètement dans la masse, soit en revêtement à l'aide d'un métal réfractaire choisi dans le groupe comprenant le tungstène, le molybdène, le tantale ou le carbure de silicium.

Dans une variante du mode de mise en œuvre précédent, le matériau réfractaire utilisé pour la pièce en forme de cadre est de la zircone ou de la thorine.

Dans le cas du silicium, préférentiellement, les bains fondus sont des mélanges de fluorures choisis parmi ceux de calcium, de magnésium et de baryum et notamment l'eutectique de composition $CaF_2MgF_2$ à 55,6 % en poids de $CaF_2$.

Selon un deuxième mode de réalisation, applicable à l'exécution du procédé en apesanteur ou en microgravité, les densités respectives du matériau métallique ou semimétallique et du bain peuvent être quelconques. Par suite de l'absence de force de gravité le matériau est toujours en équilibre indifférent dans le bain fondu.

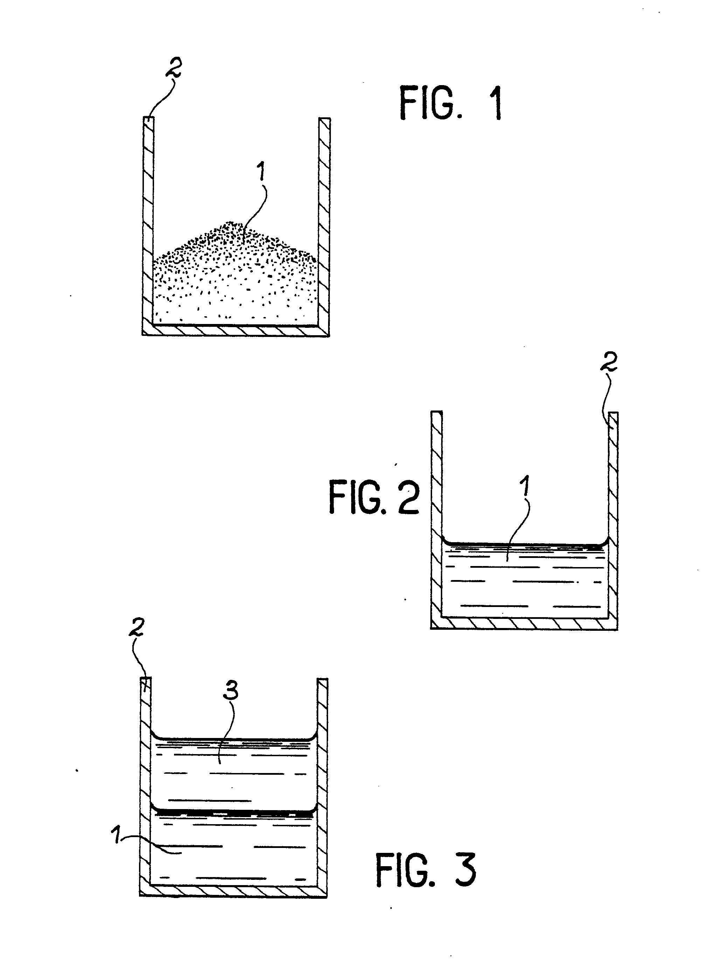

De toute façon, l'invention sera mieux comprise en se référant à la description qui suit des deux principaux modes de mise en œuvre du procédé, objet de l'invention, description qui sera faite surtout à titre illustratif et non limitatif en se référant aux figures 1 à 6 ci-jointes sur lesquelles :

la figure 1  représente un creuset de graphite rempli de silicium solide,

la figure 2  représente le même creuset après fusion du silicium à l'aide d'une source chaude non représentée,

la figure 3  représente le même creuset après addition d'un bain en fusion,

la figure 4  montre la position initiale de l'introduction et la position finale de sortie de la pièce en forme de cadre en matériau réfractaire,

la figure 5  représente le creuset en graphite rempli de bain fondu dans le cas où le matériau liquide est rassemblé au fond de ce creuset en goutte unique déformée sans mouillage envers le creuset,

la figure 6  représente la situation complémentaire de la figure 5, c'est-à-dire le cas où le bain fondu dans le creuset de graphite a une densité légèrement supérieure à celle du matériau fondu qui se rassemble sous forme d'une loupe à la surface du bain.

Sur les figures, on n'a pas représenté les moyens de chauffage et de refroidissement du creuset, nécessaires à la mise en œuvre du procédé, mais qui sont en soi d'un type connu et ne font pas partie de l'invention.

Les exemples qui suivent se rapporteront uniquement à la fabrication de plaques de silicium pour usage photovoltaïque, mais il est bien entendu que ceci ne doit pas être considéré comme limitatif du domaine d'application de l'invention et que celle-ci concerne a priori tous les matériaux métalliques ou semimétalliques que l'on souhaiterait obtenir à l'aide d'un procédé de solidification de membrane.

Les quatre premières figures dont il sera d'abord question ici concernent la description du mode de mise en œuvre du procédé, objet de l'invention, par tirage d'une membrane au sein d'une couche liquide de silicium.

A cet effet, le silicium 1 est déposé puis fondu dans un creuset de graphite ou de carbure de silicium de haute pureté 2 et maintenu en fusion jusqu'à ce que le mouillage d'équilibre soit réalisé (figure 2). On voit que le silicium liquide adhère au creuset de graphite. Un volume suffisant de bain d'enrobage 3 constitué de l'eutectique $CaF_2MgF_2$ est alors coulé à la surface du silicium. L'eutectique choisi possède, à la température de 1 450 °C, une densité légèrement inférieure à celle du silicium liquide.

Conformément à l'invention, un cadre 4, en matériau réfractaire dont le mouillage par le silicium est supérieur à celui du bain 3, et de dimensions appropriées, est alors immergé dans la couche 1 de silicium fondu. Il y est maintenu jusqu'à réaliser son mouillage continu par ce silicium liquide 1.

On procède alors à une lente extraction verticale vers le haut du cadre 4 à partir de la couche 1 et ce cadre 4 entraîne par accrochage une membrane de silicium qui demeure en place tant que le cadre 4 reste dans le volume de bain 3 surmontant le bain de silicium 1.

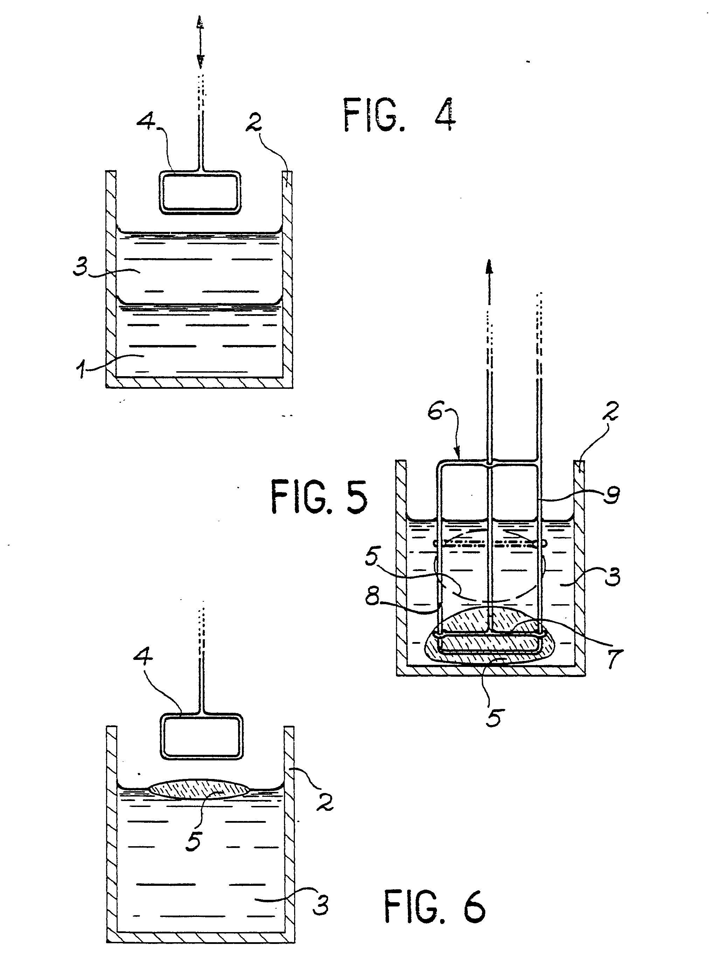

A ce moment on commence par des moyens classiques non représentés sur les figures à assurer le refroidissement de la masse liquide contenue dans le creuset 2, ce qui provoque la solidification de la plaque de silicium sur le cadre 4 et autorise le retrait de ce dernier, muni de sa plaque solide, hors du bain 3. Sur cette figure 4 on a mentionné l'utilisation d'un seul cadre. Bien évidemment on pourrait en utiliser une pluralité.

Les figures 5 et 6 illustrent une variante de mise en œuvre du procédé objet de l'invention, dans laquelle on capture le silicium par étirage d'une goutte soit en équilibre indifférent, soit positionnée au fond du creuset (figure 5) (goutte en pointillées ou en trait plein), ou flottante à la surface du bain 3 (figure 6).

A cet effet, un mélange en proportion déterminée de $CaF_2MgF_2$ et de silicium en morceaux est fondu dans un creuset 2. Si l'on règle, en modifiant sa composition, la densité du bain 3 pour qu'elle soit légèrement inférieure à celle du silicium fondu, ce dernier se rassemble alors au fond du creuset 2 sous la forme d'une goutte 5 unique qui décante lentement au fond du creuset 2 où elle demeure positionnée sous une forme proche de la sphère.

Conformément à l'invention, on introduit alors un cadre 6 déformable en matériau réfractaire mouillé de façon préférentielle par le silicium et dont le côté inférieur 7 peut coulisser le long de ses montants verticaux latéraux 8 et 9. C'est le côté inférieur 7 que l'on amène au contact de la goutte de silicium 5 qui adhère alors au cadre 6 et s'étire partiellement sur les montants du cadre 8 et 9. L'extension de la goutte 5 est achevée par le mouvement ascendant du côté mobile 7 du cadre jusqu'à la dimension désirée pour la plaque.

La solidification du silicium peut alors commencer par refroidissement dirigé du liquide contenu dans le creuset 2 à l'aide de moyens classiques et non représentés sur la figure 5 et cette solidification s'achève avant l'extraction complète de la plaque de silicium hors du bain fondu 3.

Dans une variante de ce procédé, on augmente au contraire la densité du bain 3 pour que la position d'équilibre de la goutte de silicium 5 soit en surface du sel fondu 3 sous forme d'une loupe. Un cadre 4 non déformable est alors descendu à travers la loupe de silicium 5 pour entraîner son accrochage, et son étirement vers le bas jusqu'à immersion dans le bain 3. La solidification se fait comme dans les exemples précédents, de manière directionnelle. Dans une variante du procédé destinée à former des volumes quelconques, les cadres utilisés ont des géométries qui correspondent aux arêtes des volumes désirés. Ces volumes peuvent être pleins ou vides du matériau métallique ou semimétallique.

Les explications générales concernant le procédé objet de l'invention ayant été ainsi fournies, on donnera maintenant trois exemples concrets d'application du procédé, objet de l'invention, à la fabrication de plaques de silicium par solidification de membranes.

Exemple 1

On utilise un creuset de graphite cylindrique contenant un volume de silicium liquide sur une hauteur d'environ 8 cm.

Le silicium liquide adhère au graphite au bout de 30 min. de maintien en température à 1450 °C sous atmosphère d'argon.

Un volume d'eutectique $CaF_2MgF_2$ fondant à 980 °C est alors coulé à la surface du silicium liquide pour former une couche d'environ 8 cm de haut.

Dès la fin de cette opération, un cadre de tungstène de forme carrée et de 5 cm d'arête est immergé rapidement dans le bain de silicium à travers la couche de l'eutectique fondu.

Après un temps de maintien de l'ordre de 3 min., le cadre est retiré du silicium à une vitesse de 1 cm par minute.

Une membrane de silicium est alors entraînée par le cadre. Lorsque celui-ci est hors du bain de silicium, mais toujours dans le milieu de l'eutectique fondu, la solidification commence par refroidissement orienté et programmé.

Le cadre et la membrane solidifiée sont alors retirés du bain. Une deuxième opération peut alors commencer par remise en fusion de la masse de silicium.

Exemple 2

Un creuset de graphite pur contenant de l'eutectique $CaF_2MgF_2$ et du silicium en quantité suffisante correspondant à la plaque désirée est chauffé jusqu'au-delà de la fusion du silicium, soit environ 1450 °C.

Le silicium se rassemble alors systématiquement sous forme d'une goutte unique sous l'action des propriétés tensioactives des milieux en présence.

Cette goutte se positionne en bas du creuset de graphite.

Un cadre de tungstène de forme extensible, mais en configuration réduite est alors introduit jusqu'à contacter la goutte de silicium (figure 5). Le silicium, par mouillage, s'accroche sur les montants rapprochés du cadre et se stabilise en quelques minutes.

Le développement de la surface du cadre peut alors commencer par un mouvement vertical de son montant inférieur 7 à une vitesse de l'ordre de 1 cm par minute. Lorsque le cadre est développé, la membrane de silicium accrochée est alors solidifiée dans son environnement de l'eutectique liquide avant d'être retirée.

Exemple 3 (figure 6)

Comme dans l'exemple 2, la goutte de silicium est formée dans un bain dans ce cas, de densité supérieure au silicium liquide. Sa densité est ajustée par l'emploi de fluorure de baryum ; à cet effet, on peut utiliser le mélange binaire à 70 % de $CaF_2$ et 30 % de $BaF_2$ en poids qui permet une sustentation suffisante mais non trop forte de la goutte de silicium à la surface du bain, de façon à former une loupe.

Le cadre de tungstène indéformable est alors amené à contacter la loupe de silicium et celle-ci s'étend par capillarité horizontalement jusqu'à toucher les deux montants latéraux du cadre. Il ne faut pas que la densité du bain soit très supérieure à celle du silicium liquide, car il serait impossible de former une plaque, la goutte de silicium ayant des difficultés à descendre par entraînement capillaire.

L'immersion se poursuit à 1 cm par minute jusqu'à être complète. La membrane entraînée au sein du bain est alors solidifiée de manière dirigée puis est retirée du bain.

Une deuxième goutte peut être introduite dans ce bain et l'opération continuée selon la même procédure avec un autre cadre.

L'invention toutefois n'est pas limitée de façon stricte au procédé de préparation de plaques métalliques qui a été décrit, mais peut s'étendre, si on le souhaite, à l'obtention de formes, de volumes, définis par les arêtes de cadres de diverses formes géométriques et les faces de silicium liquide maintenu entre ces arêtes. On peut obtenir ainsi des cuves de silicium ou des formes parallélépipédiques à faces parallèles ou mêmes gauches. A cet effet, des pièces jouant le rôle du cadre précédent pour l'obtention de plaques métalliques planes, peuvent être réalisées à l'aide de formes parallélépipédiques en barreaux de tungstène ou d'autres matériaux réfractaires mouillés préférentiellement par le silicium.

De plus, il est entendu que dès lors que le métal ou l'alliage fondu a une densité voisine de celle du bain d'enrobage liquide chimiquement inerte vis-à-vis de ce métal ou de cet alliage, on peut utiliser le procédé objet de l'invention pour obtenir des solides ayant les différentes formes précédentes à partir de ces métaux ou alliages. Les matériaux constituant le cadre sont alors toujours choisis pour être préférentiellement mouillés par le métal ou l'alliage.

Enfin, des matériaux fondus de formes diverses peuvent être obtenus selon le procédé objet de l'invention en état d'apesanteur ou de microgravité à bord de satellites artificiels du globe terrestre.

## Revendications

1. Procédé de préparation de formes métalliques ou semimétalliques, notamment de silicium, en bain d'enrobage fondu (3), du genre de ceux dans lesquels on met dans un creuset de confinement (2) le matériau métallique ou semimétallique de base (1) fondu et un bain d'enrobage fondu (3) inerte vis-à-vis du matériau et dont la température de fusion est inférieure à celle du matériau, caractérisé en ce que l'on introduit dans le matériau au moins une pièce en forme de cadre (4), en un matériau réfractaire dont l'aptitude au mouillage est plus grande vis-à-vis du matériau métallique ou semimétallique que vis-à-vis du bain d'enrobage fondu, puis on crée sur ce cadre, par déplacement lent de tout ou partie de celui-ci, une forme de ce matériau métallique ou semimétallique que l'on solidifie dans le bain d'enrobage liquide pour extraire enfin l'ensemble du cadre et de la membrane solidifiée hors du bain.

2. Procédé de préparation de formes métalliques selon la revendication 1, caractérisé en ce que le bain fondu a une densité légèrement inférieure à celle du matériau métallique ou semimétallique fondu, celui-ci adhérant alors par mouillage au fond du creuset de confinement.

3. Procédé de préparation de formes métalliques selon la revendication 1, caractérisé en ce que le bain fondu a une densité égale ou très voisine de celle du matériau métallique ou semimétallique fondu et celui-ci se rassemble sous forme d'une goutte unique (5) de forme voisine de la sphère dans le creuset et en ce que la pièce en forme de cadre (6) est déformable, l'un des côtés (7) du cadre étant monté coulissant le long des deux autres côtés adjacents (8, 9).

4. Procédé de préparation de formes métalliques selon la revendication 1, caractérisé en ce que le bain fondu a une densité légèrement supérieure à celle du matériau métallique ou semimétallique fondu, celui-ci se rassemblant alors sous forme de loupe flottant à la surface du bain et en ce que le cadre est introduit à travers la loupe de silicium (5) dans le bain fondu.

5. Procédé de préparation de formes métalliques ou semimétalliques selon l'une des revendications 1 à 4 précédentes, caractérisé en ce que le matériau étant du silicium, la pièce en forme de cadre est réalisée, dans la masse ou en revêtement, à l'aide d'un métal réfractaire choisi dans le groupe comprenant le tungstène, le molybdène, le tantale ou le carbure de silicium.

6. Procédé de préparation de formes métalliques ou semimétalliques selon l'une des revendications 1 à 4 précédentes, caractérisé en ce que le matériau étant du silicium, la pièce en forme de cadre est réalisée, dans la masse ou en revêtement, à l'aide d'un oxyde réfractaire tel que la thorine ou la zircone.

7. Procédé de préparation de formes métalliques selon l'une quelconque des revendications 5 et 6, caractérisé en ce que le bain fondu est un mélange de fluorures choisis parmi ceux de calcium, de magnésium et de baryum.

8. Procédé de préparation de formes métalliques ou semimétalliques selon la revendication 1, caractérisé en ce que les densités respectives du bain et du matériau sont quelconques, l'exécution se réalisant en apesanteur ou microgravité.

## Claims

1. Process for the preparation of metallic or semimetallic shapes, made of silicon in particular, in a molten coating bath (3), of the kind in which the molten metallic or semimetallic base material (1) and a molten coating bath (3) which is inert towards the material and whose melting point is below that of the material, are placed in a confining crucible (2), characterized in that at least one frame-shaped member (4), made of a refractory material whose wettability by the metallic or semimetallic material is greater than that by the molten coating bath, is introduced into the material, and that there is then created on this frame, by a slow displacement of all or a portion thereof, a shape made of this metallic or semimetallic material which is solidified in the liquid coating bath in order to finally extract both the frame and the solidified membrane from the bath.

2. Process for the preparation of metallic shapes according to Claim 1, characterized in that the molten bath has a density which is slightly lower than that of the molten metallic or semimetallic material, the latter then adhering to the bottom of the confining crucible by wetting.

3. Process for the preparation of metallic shapes according to Claim 1, characterized in that the molten bath has a density which is equal or very close to that of the molten metallic or semimetallic material and the latter collects in the form of a single drop (5) of nearly spherical shape in the crucible and in that the frameshaped member (6) can be deformed, one of the sides (7) of the frame being mounted to slide along the other two adjacent sides (8, 9).

4. Process for the preparation of metallic shapes according to Claim 1, characterized in that the molten bath has a density which is slightly higher than that of the molten metallic or semimetallic material, the latter then collecting in the form of a lens floating at the surface of the bath and in that the frame is introduced into the molten bath through the silicon lens (5).

5. Process for the preparation of metallic or semi-metallic shapes according to one of the preceding Claims 1 to 4, characterized in that, the material being silicon, the frame-shaped member is made, in its bulk or as a coating, using a refractory metal chosen from the group comprising tungsten, molybdenum, tantalum or silicon carbide.

6. Process for the preparation of metallic or semi-metallic shapes according to one of the preceding Claims 1 to 4, characterized in that, the material being silicon, the frame-shaped member is made, in its bulk or as a coating, using a refractory oxide such as thoria or zirconia.

7. Process for the preparation of metallic shapes according to either of Claims 5 and 6, characterized in that the molten bath is a mixture of fluorides chosen from those of calcium, of magnesium and of barium.

8. Process for the preparation of metallic or semi-metallic shapes according to Claim 1, characterized in that the respective densities of the bath and of the material are unspecified, the implementation taking place in the absence of gravity or under microgravity.

**Patentansprüche**

1. Verfahren zur Herstellung von metallischen oder halbmetallischen Gegenständen, insbesondere von Silizium, im Überdeckungsbad (3), bei dem man in ein Schmelzgefäß (2) das geschmolzene, metallische oder halbmetallische Grundmaterial (1) und ein geschmolzenes Überdeckungsbad (3) eingibt, welches in Bezug auf das Material inert ist und dessen Schmelztemperatur niedriger als diejenige des Materials ist, dadurch gekennzeichnet, daß man in das Material wenigstens ein rahmenförmiges Teil (4) aus einem hitzebeständigen Material einbringt, dessen Benetzungsvermögen in Bezug auf das metallische oder halbmetallische Material größer als in Bezug auf das geschmolzene Überdeckungsbad ist, daß man an dem Rahmen durch langsame Verschiebung des gesamten Rahmens oder eines Teils von diesem eine Gestaltung aus diesem metallischen oder halbmetallischen Material erzeugt, die man in dem flüssigen Überdeckungsbad verfestigt, um schließlich die Gesamtheit aus Rahmen und der verfestigten Membran aus dem Bad herauszuziehen.

2. Verfahren zur Herstellung eines metallischen Gegenstandes nach Anspruch 1, dadurch gekennzeichnet, daß das geschmolzene Bad eine etwas geringere Dichte als diejenige des geschmolzenen, metallischen oder halbmetallischen Materials aufweist, welches dann durch Benetzung am Boden des Schmelzgefäßes haftet.

3. Verfahren zur Herstellung eines metallischen Gegenstandes nach Anspruch 1, dadurch gekennzeichnet, daß das geschmolzene Bad eine Dichte aufweist, die gleich oder sehr nahe derjenigen des geschmolzenen, metallischen oder halbmetallischen Materials ist und sich dieses als ein einziger Tropfen (5) mit einer einer Kugel ähnlichen Form in dem Schmelzgefäß sammelt, und daß der Teil in der Form eines Rahmens (6) verformbar ist, wobei eine (7) der Seiten des Rahmens verschiebbar längs der zwei anderen benachbarten Seiten (8, 9) angebracht ist.

4. Verfahren zur Herstellung eines metallischen Gegenstandes nach Anspruch 1, dadurch gekennzeichnet, daß das geschmolzene Bad eine Dichte aufweist, die etwas größer als diejenige des geschmolzenen, metallischen oder halbmetallischen Materials ist, das sich dann als an der Oberfläche des Bades schwimmende Linse sammelt, und daß der Rahmen quer zu der Linse aus Silizium (5) in das geschmolzene Bad eingeführt wird.

5. Verfahren zur Herstellung eines metallischen oder halbmetallischen Gegenstandes nach einem der Ansprüche 1 bis 4, dadurch gekennzeichnet, daß das Material Silizium ist, daß das rahmenförmige Teil insgesamt oder mit einem Überzug aus einem hitzebeständigen Metall hergestellt ist, welches aus der Wolfram, Molybdän, Tantal oder Siliziumkarbid umfassenden Gruppe ausgewählt ist.

6. Verfahren zur Herstellung eines metallischen oder halbmetallischen Gegenstandes nach einem der Ansprüche 1 bis 4, dadurch gekennzeichnet, daß das Material Silizium ist, daß das rahmenförmige Teil insgesamt oder mit einem Überzug aus einem hitzebeständigen Oxid wie Thoriumoxid oder Zirkonoxid hergestellt ist.

7. Verfahren zur Herstellung eines metallischen Gegenstandes nach Anspruch 5 oder 6, dadurch gekennzeichnet, daß das geschmolzene Bad eine Mischung aus Fluoriden ist, die aus denen des Calziums, des Magnesiums und des Bariums ausgewählt sind.

8. Verfahren zur Herstellung eines metallischen oder halbmetallischen Gegenstandes nach Anspruch 1, dadurch gekennzeichnet, daß die entsprechenden Dichten des Bades und des Materials beliebig sind, wobei die Durchführung mittels Schwerelosigkeit oder Mikrogravidation erfolgt.

FIG. 1

FIG. 2

FIG. 3

FIG. 4

FIG. 5

FIG. 6